**Europäisches Patentamt**

(19) **European Patent Office**

**Office européen des brevets**

(11) Publication number : **0 405 877 B1**

(12) # EUROPEAN PATENT SPECIFICATION

(45) Date of publication of patent specification :
16.03.94 Bulletin 94/11

(51) Int. Cl.⁵ : **H01L 29/06, H01L 23/367, H01L 29/784**

(21) Application number : **90306902.9**

(22) Date of filing : **25.06.90**

(54) **Thermally optimized interdigitated transistor.**

(30) Priority : **30.06.89 US 374422**

(43) Date of publication of application :
**02.01.91 Bulletin 91/01**

(45) Publication of the grant of the patent :
**16.03.94 Bulletin 94/11**

(84) Designated Contracting States :
**DE FR GB IT NL**

(56) References cited :
**GB-A- 2 175 441**
**IBM TECHNICAL DISCLOSURE BULLETIN vol. 30, no. 4, September 1987, pages 1471-1477, Armonk, NY, US; "Techniques for Parasitic Capacitance Minimization"**

(73) Proprietor : **TEXAS INSTRUMENTS INCORPORATED**
**13500 North Central Expressway**
**Dallas Texas 75265 (US)**

(72) Inventor : **Pritchett, Samuel D.**
**1309 Blum Court**
**Flower Mound, Texas 75028 (US)**

(74) Representative : **Abbott, David John et al**
**Abel & Imray Northumberland House 303-306 High Holborn**
**London, WC1V 7LH (GB)**

## Description

### TECHNICAL FIELD OF THE INVENTION

The present invention relates to the thermal optimization of transistors, and more particularly to a thermally optimized quasi-interdigitated radio frequency power transistor.

### BACKGROUND OF THE INVENTION

Solid-state power amplifiers have received considerable attention since the invention of the solid-state transistor and the solid-state integrated circuit. Heat is generated in the active regions of field effect transistors (FETs) and bipolar junction transistors (BJTs) as a result of $I^2R$ losses. This heat affects the reliability and thus the mean time before failure (MTBF) of these transistors. Fourier's law of heat conduction describes the spatial flow of heat through a substance by the following one-dimensional expression:

$$q = k \frac{dT}{dx} \quad (1)$$

where q, the heat flux, is a heat rate per unit area; k is the thermal conductivity of the conducting medium; T is the temperature; and d/dx is the differential with respect to distance. The more general form is the vector expression:

$$\overline{q} = -k \nabla T \quad (2)$$

where overstruck quantities represent vector quantities and the symbol $\nabla$ represents the differential operator DEL.

The semiconductor chip in which a solid-state power amplifier is built is typically mounted on a metal or composite material having a thermal conductivity that is at least two times greater than the thermal conductivity of the semiconductor, $k_{semi}$. As a result, $k_{semi}$ is generally the limiting component in heat dissipation from the power amplifier.

The thermal conductivity of the semiconductor, ksemi is a function of temperature. For temperatures above approximately 20K, $k_{semi}$ can be expressed by the following relation:

$$k_{semi} = k_O \frac{T_O}{T} \quad (3)$$

where $k_O$ is the thermal conductivity of the conducting medium at the reference temperature, $T_O$ is the reference temperature, and T is the temperature of the conducting medium. The reference temperature, $T_O$, is generally room temperature or, in degrees Kelvin, approximately 300K. For pure silicon (Si) and gallium arsenide (GaAs), the values for $k_O$ are $1.45 \pm 0.05$ and $0.44 \pm 0.04$ W/cm-K, respectively.

When semiconductor impurity (i.e. dopant) concentrations exceed $10^{15}$ atoms/cm$^3$, the thermal conductivity of the conducting medium is reduced. This results from electron-phonon interaction. In typical semiconductor devices, $k_{semi}$ will not degrade more than approximately 20% due to semiconductor impurities.

Reliability studies indicate that the active temperature for semiconductor regions, $T_{active}$, should not exceed about 150°C. Ambient operating temperatures of many semiconductors are approximately 85°C. Because of these limitations, the density of rf power generated by a power amplifier transistor must be maintained below a predetermined threshold, $P_{Dmax}$, to maintain an acceptable operating temperature and therefore MTBF.

Conventionally, rf power density has been increased while minimizing the overall chip width W by interdigitating small transistor sections or heat-generating regions. These transistor sections are placed as close as possible to each other while maintaining $T_{active}$ below an acceptable value during device operation.

In high-frequency applications, another problem arises. As the width of the cavity (approximately equal to the chip width, W) in which the transistor is mounted, increases, waveguide resonating modes become possible. These modes effectively feed back a portion of the rf energy to the input of the transistor. This increases the loss of the circuit and can also cause unwanted transistor oscillations. Waveguide resonating modes are strongly attenuated when the width of the cavity is less than half of the effective wavelength, $\lambda/2$ at the frequency of device operation.

A problem inherent in these conventional interdigitating transistor structures is that adjacent transistor sections contribute significantly to the heat dissipation required by neighboring transistor sections. As a result of demands for increased rf power in system applications at higher and higher frequencies, the standard interdigitated transistor structure is no longer sufficient.

Another conventional approach is to use thinner semiconductor substrates. This increases the dT/dz, where z is in the direction of the substrate thickness, and causes increased heat transfer. However, in many integrated circuit applications, such as monolithic microwave integrated circuits, certain other components such as distributed transmission lines fix lower limits on substrate thickness.

From the above, it can be seen that a need has arisen for a high-frequency rf power transistor having acceptable heat dissipation while being capable of generating increased rf power within fixed physical dimensions.

According to the present invention there is provided an integrated circuit formed at the face of a semiconductor layer, comprising a plurality of separate transistors formed at said face, three metallic contact regions respectively connected to the three electrode regions of the transistors so that the transistors are connected in parallel, each transistor having an active region where heat is generated during operation of the integrated circuit;

the heat-generating regions being disposed along an arcuate path, so that the heat-generating regions are spaced from one another in a first direction and substantially all of the heat-generating regions are offset from one another at both ends in a second direction perpendicular to the first direction, thereby facilitating the dissipation of heat originating from the heat-generating regions.

In one embodiment of the invention, each heat generating region, which for example may be a channel region of a field effect transistor, has a center positioned on a V-shaped line such that more transistors including these sections may be fit within a predetermined cavity dimension (w) in the transverse direction that is less than half of the effective operating wavelength, thereby avoiding waveguide resonating mode problems. Another technical advantage of the invention is that the V-shaped arrangement of the channel regions with respect to one another can be outwardly curved. The transverse spacing between adjacent channel regions and the ends of the "V" are set at a predetermined distance to meet each region's dissipation requirements. As each branch of the "V" curves inwardly to a longitudinal axis of the transistor, the transverse spacing between adjacent channel sections can be decreased because of the increased offset.

The V-shaped arrangement provides another technical advantage in that it provides an anti-symmetric combination of the signal from the various signal paths. Therefore, there is little or no phase cancellation experienced within the device and accordingly no loss of power for this reason as is usually experienced in conventional interdigitated transistors.

In a preferred embodiment of the invention, the power transistor is a junction field effect transistor. A drain contact and a gate contact are positioned on a longitudinal axis. A pair of gate manifolds extend from the gate contact longitudinally toward the drain contact and transversely outward from the longitudinal axis. A plurality of channel regions are formed between the gate manifolds and the drain contact on the "V" shaped pattern as described above. Each of the gate regions has its electrical conductance controlled by a respective gate electrode that is conductively coupled to one of the gate manifolds.

Each of the channel regions has associated with it a drain region that is preferably formed as a diffused finger that extends from the drain contact. For each channel region there is further a source region that is electrically coupled to one of two source contacts through a metal air bridge over one of the gate manifolds.

The present invention provides significant technical advantages in that it affords a transistor design having a width or transverse dimension that is smaller, but which at the same time increases the heat dissipation ability of the transistor while in operation and avoids losses due to phase cancellation from multiple parallel signal paths. The transistor of the invention may therefore be operated at higher power and higher rf frequencies, and more of the transistors may be fit onto a chip having a width w that is less than $\lambda/2$.

## BRIEF DESCRIPTION OF THE DRAWINGS

Further aspects of the invention and their advantages may be discerned by referring to the following detailed description when taken in conjunction with the drawings, in which:

FIGURE 1 is a schematic diagram of a three-dimensional coordinate system useful for explaining the invention;

FIGURE 2 is a highly schematic isometric view of an interdigitated transistor according to the prior art;

FIGURE 3 is a highly schematic isometric view of a quasi-interdigitated transistor according to the invention, illustrating advantages in heat dissipation;

FIGURE 4 is a highly magnified, schematic plan view of a microwave signal power amplifier transistor as incorporating the invention; and

FIGURE 5 is a more detailed view of one half of the transistor illustrated in FIGURE 4.

## DETAILED DESCRIPTION OF THE INVENTION

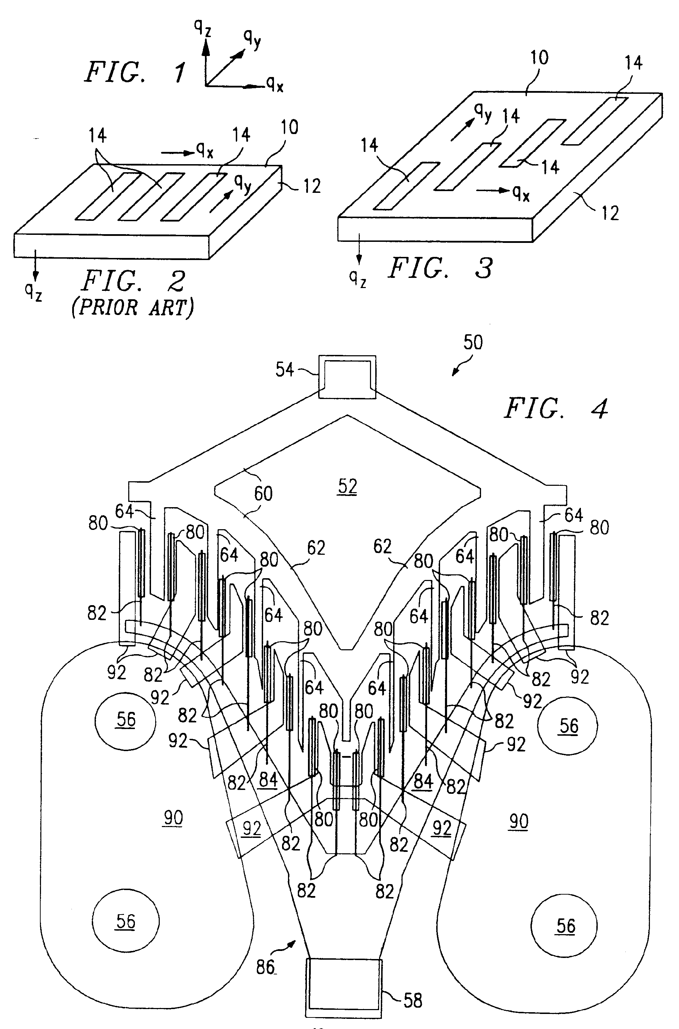

From any point of a heat-generating region in a semiconductor device such as a power transistor, heat dissipation may be resolved into three vector components: x, y and z, corresponding to the axes of a typical three-dimensional coordinate system as shown in FIGURE 1.

FIGURE 2 is a highly schematic isometric view of a interdigitated transistor according to the prior art. According to conventional practice, the transistor is formed at a face 10 of a semiconductor substrate or bulk semiconductor 12. The substrate 12 generally has a thickness in the z-direction that is much less than its length or width in the y or x-directions, respectively. The transistor comprises a plurality of heat-generating sections 14, which in the case of field-effect transistors are the channel regions disposed between neighboring source and drain regions (not shown). The principle of the invention is also applicable to bipolar devices, wherein the heat generating regions 14 would comprise entire bipolar devices.

In operation, each of the heat-generating regions 14 will originate heat that is transferred in the x-, y- and z-directions. The vectors labeled $q_x$, $q_y$, and $q_z$ represent the heat transfer in these appropriate directions.

The temperature differential in the z-direction, dT/dz, is greater than the temperature differential in the x- and y-directions, dT/dx and dT/dy, respectively. This results from the thermal conductivity of the metal or composite material (not shown) on which the semiconductor chip 12 is mounted. For the purpose of analyzing heat transfer, the thermal conductivity of the metal or composite mounting material may be considered infinite and at a constant temperature, $T_{sink}$.

Provided that the thickness z of the semiconductor substrate 12 and $T_{active}$ are fixed, the only possible way to reduce the spacing between adjacent transistor heat-generating sections 14 is to reduce the contribution of $q_x$ from neighboring transistor sections.

Referring now to FIGURE 3, a highly schematic isometric view of a quasi-interdigitated transistor according to the invention is shown. Like numbers identify like parts between FIGURES 2 and 3. As can be seen, the position of adjacent transistor sections 14 is shifted in the y-direction to reduce the contribution of $q_x$ from neighboring transistor sections 14. The partial removal of the $q_x$ component of heat from adjacent transistor sections 14 allows the interdigitated transistor to dissipate heat more efficiently, assuming all other factors to be the same, and therefore the transistor may be operated at a higher power and at lower or equal $T_{active}$.

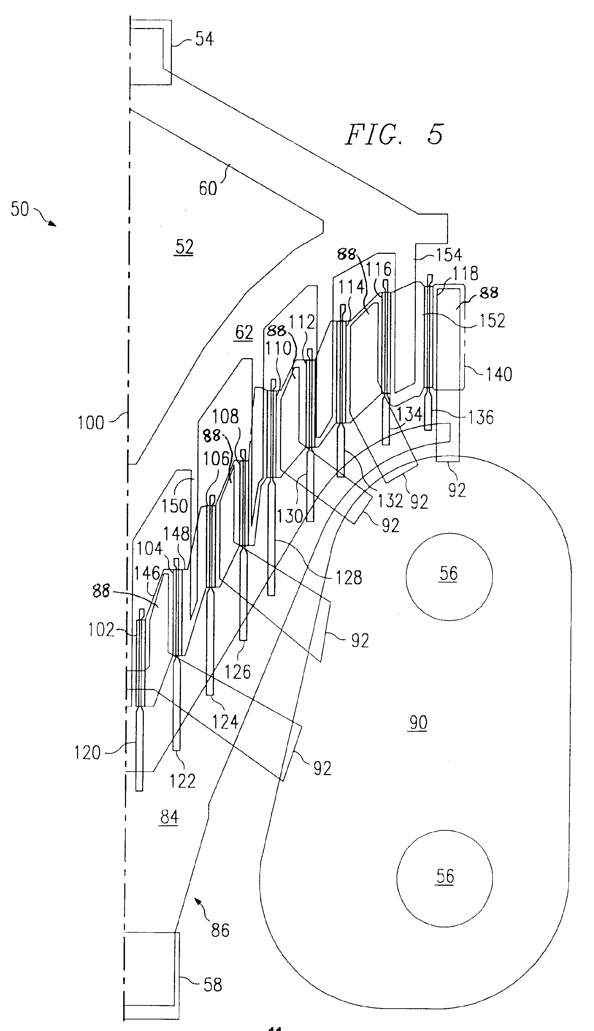

The offset of the individual transistor sections 14 in the y-direction can be realized in actual devices in several fashions. An example of one possible realization is illustrated in FIGURES 4 and 5. FIGURE 4 is a highly magnified schematic plan view of a quasi-interdigitated transistor for use in microwave power applications. This transistor is indicated generally at 50, and is formed at a face of a semiconductor substrate 52. Only certain components of transistor 50 are shown in FIGURE 4 for the sake of clarity.

Transistor 50 is a metal semiconductor field effect transistor (MESFET). A drain contact is indicated at 54. Connection is made to other amplifier components through the drain contact 54, a plurality of source vias 56 and a gate contact 58. Each of these contacts is made through a passivating dielectric layer (not shown) to the face of the semiconductor substrate 52.

The drain contact 54 is conductively connected to a metallized drain manifold, the outline of which is indicated at 60. In the illustrated embodiment, the drain manifold 60 takes a hollow diamond-shaped pattern, and includes a pair of lower arms 62. A plurality of metallized drain contact fingers 64 extend from the lower drain manifold arm 62 longitudinally in the direction of the gate contact 58. Each of the drain contact fingers 64 makes connection to a respective drain region (not shown; see FIGURE 5) that is diffused into the semiconductor layer 52.

The transistor 50 is provided with a plurality of channel regions 80. The channel regions 80 are the source of most of the heat generated during operation of the transistor 50, such that their locations may dictate the modelling of the entire device 50. Each of the channel regions 80, where for instance the substrate 52 is gallium arsenide, is an elongate rectangle of (N) type material between a respective drain region and a respective source region (both later described), with the length of each channel region 80 in a longitudinal or y-direction being much greater than its width in a transverse or x-direction. (In FIGURE 4, y is in a vertical direction, while x is in the horizontal direction).

Each of the rectangular channel regions 80 is offset in a y-direction from the adjacent channel regions 80. Each of the channel regions 80 is connected through a metal conductor shown schematically at 82 to one of two metal arms 84 of a gate manifold indicated generally at 86. The gate manifold 86 is in turn connected to the gate contact 58.

Disposed on one side of each of the channel regions 80 is a respective source region 88 (not shown; see FIGURE 5). Each source region 88 is diffused into the semiconductor substrate 52 to be (N+), where the drain regions are also selected to be (N+). Each source region 88 is connected to one of two metal source contact pads 90 through a respective conductive air bridge 92 that is insulatively separated from the gate manifold arm 84 over which it passes by both a dielectric passivating layer (not shown) and air.

A longitudinal one-half of the transistor 50 is shown in more detail in FIGURE 5. The y axis is indicated at 100, and only the right one-half of the transistor 50 is shown. Channel regions 102-118 are not offset by a constant amount as one proceeds transversely from the y axis 100. Instead, the longitudinal centers of the channel regions 102-118 fall on a curved V-shaped locus that extends from the y axis 100 in a longitudinal direction toward the drain contact 54, while progressively curving transversely. More inwardly disposed channel regions 102-108 are offset from each other in the y-direction by a fairly constant amount. The incremental offset of the more outer channel regions 110-118 from each other, and from channel region 108, begins to decrease as one proceeds in a transverse direction from the y-axis 100. This arcuate or serpentine positioning was optimized using a thermal modelling program incorporating a finite difference technique.

Each of the channel regions 102-118 has a corresponding gate electrode 120-136 that is bonded directly to the surface of its respective channel region 102-118. To improve Schottky junction breakdown, each gate electrode 120-136 is recessed into the face of the semiconductor substrate 52. While each channel region is associated with only one gate electrode in the illustrated embodiment, the invention also applies to channel regions having multiple electrodes.

The separation of the channel regions 102-118 in an x or transverse direction increases as one proceeds from the y-axis. This is because there is more y-offset between adjacent channel regions near the axis 100, and relatively less y-offset of adjacent channel regions further from the axis 300. Because of this, the heat component $\bar{q}_x$ from any channel region adjacent to a channel region that is relatively removed from the axis 100 becomes a greater concern, and a further transverse spacing is required in comparison to those channel regions nearer the axis 100.

The illustrated transistor 50 is preferably formed on a chip with several other like transistors in a single row in the x-direction. The chip width w must be kept less than the waveguide cutoff frequency, $\lambda/2$, to prevent waveguide resonating modes and feedback of a portion of the rf energy to the inputs of the transistor 50. The arcuate V design of the transistor of the invention allows a sufficiently close spacing of adjacent channel regions 102-118 that a smaller w becomes possible for any particular power application. Meanwhile, thermal optimization has insured that a constant channel or junction temperature $T_{active}$ is maintained throughout all of the channel regions 102-118.

Another advantage of the invention is its antisymmetric combining structure. The signal appears at the gate contact 58, and is amplified by the various transistor sections to appear at the drain contact 54 through a plurality of multiple parallel paths. Each one of these multiple parallel paths has a propagation time delay associated with it. For example, in one path, the signal proceeds from the gate contact 58 to the gate manifold 86 and starts up the gate manifold arm 84. It proceeds up a gate conductor 122, where it is amplified with current supplied from a channel region 104. The amplified signal continues through drain region 148, and travels through an associated drain contact finger 150 to the drain contact arm 62 and from thence to the drain contact 54.

In another parallel path, the signal proceeds all the way up the gate contact manifold arm 84 to a gate conductor 118. The signal as amplified continues through at a drain region 152 and proceeds from thence to a drain finger 154 to the drain manifold 60 and the drain contact 54. These two parallel paths, and various other signal paths in between, experience approximately the same time delay, since as the length from the gate contact 58 to a particular channel region 102-118 increases, the length from an associated drain region to the drain contact 54 decreases. Hence, there will be no signal phase cancellation within the device due to different time propagation delays experienced by multiple parallel paths.

In summary, a novel quasi-interdigitated transistor has been described, wherein multiple channel regions are offset from one another in reference to a particular axis to remove a portion of the heating experienced by adjacent channel regions. The transistor has been modelled to maintain a uniform $T_{active}$ for each channel region in the device, while at the same time having a transverse dimension that is less than the waveguide cutoff frequency. The transistor of the invention has the further advantage of equal time propagation delays associated with multiple signal paths.

## Claims

1. An integrated circuit (50) formed at the face of a semiconductor layer (52), comprising a plurality of separate transistors (14) formed at said face, three metallic contact regions (90,92;84,86; 62,64) respectively connected to the three electrode regions of the transistors so that the transistors are connected in parallel, each transistor having an active region (80) where heat is generated during operation of the integrated circuit;

   the heat-generating regions being disposed along an arcuate path, so that the heat-generating regions are spaced from one another in a first direction and substantially all of the heat-generating regions are offset from one another at both ends in a second direction perpendicular to the first direction, thereby facilitating the dissipation of heat originating from the heat-generating regions.

2. An integrated circuit according to claim 1, wherein said arcuate path of heat generating regions is V-shaped.

3. An integrated circuit according to claim 1, wherein:

   each of said heat generating regions has a centre, the locus of said centres forming a V-shaped curve having arms extending transversely from a y-axis aligned with said second direction, each said arm making a first angle with said y-axis near said y-axis and curving to a second angle with said y-axis at the ends thereof, said second angle being larger than said first angle with respect to said y-axis; and

   the distances between the centres of each said heat-generating region and centres of adjacent heat-generating regions in a transverse direction increasing as a function of the distance of said heat-generating region from said y-axis to maintain a substantially constant heat-generating region temperature throughout said transistors.

4. An integrated circuit according to claim 1, 2 or 3, wherein said transistors are field effect transistors, each of said heat-generating regions comprising a channel region, disposed between a respective drain region and a source region disposed on opposite sides of each said channel region, each of said drain regions being connected in common, each of said source regions being connected in common.

5. An integrated circuit according to claim 4, including:

a conductive drain contact formed at said face;

a conductive gate contact formed at said face to be spaced in the second direction from said drain contact;

first and second conductive source contacts formed at said face transversely spaced from said gate contact;

a first conductive elongate gate manifold formed at said face to be spaced between said first source contact and said drain contact, said first gate manifold being electrically connected to said gate contact and extending therefrom diagonally towards said drain contact in a direction between the first and second directions;

a second conductive elongate gate manifold formed at said face to be spaced between said second source contact and said drain contact, said second gate manifold being electrically connected to said gate contact and extending therefrom diagonally towards said drain contact and away from said first gate manifold;

a plurality of drain regions formed at said face, each said drain region being electrically connected to said drain contact and spaced from each other, each drain region being formed between said drain contact and a predetermined one of said gate manifolds;

a plurality of source regions formed at said face and spaced from and interdigitated with said drain regions, each source region being electrically connected to a preselected one of said source contacts;

a plurality of channel regions defined in said layer between respective ones of said source regions and said drain regions, each said channel region being elongate in the second direction; and

for each region, at least one conductive gate electrode disposed adjacent thereto and electrically connected to a predetermined one of said gate manifolds.

6. An integrated circuit according to claim 5, wherein each said channel region has a plurality of gate electrodes disposed adjacent thereto.

7. An integrated circuit according to claim 5 or 6, further comprising a plurality of conductive air bridges, each air bridge formed to span a respective gate manifold and connecting one of said source contacts to a respective source region.

8. An integrated circuit according to claim 5, 6 or 7, wherein said drain regions comprise a plurality of substantially parallel elongate drain fingers extending from said drain region in the second direction towards said gate contact, said drain contact including a diffused region in said semiconductor layer, each said drain finger being an integral extension of said drain contact diffused region.

9. An integrated circuit according to any one of claims 5 to 8, wherein said transistors are metal-semiconductor field-effect transistors.

10. An integrated circuit according to any one of claims 5 to 9, wherein said transistors produce a signal at said drain contact, and the cumulative dimension on the first direction of said transistors is less than one half of an effective wavelength of said signal.

11. An integrated circuit according to any one of the preceding claims, further comprising a signal input and a signal output, a plurality of parallel signal paths extending from said signal input to said signal output;

the signal paths being associated with respective transistors and having substantially the same signal propagation time delay.

**Patentansprüche**

1. An der Oberseite einer Halbleiterschicht (52) gebildete integrierte Schaltung (50) mit mehreren an diese Oberseite gebildeten getrennten Transistoren (14), drei metallischen Kontaktzonen (90, 92; 84, 86; 62, 64), die jeweils mit den drei Elektrodenzonen der Transistoren verbunden sind, so daß die Transistoren parallelgeschaltet sind, wobei jeder Transistor eine aktive Zone (80) aufweist, in der während des Betriebs der integrierten Schaltung Wärme erzeugt wird; wobei die wärmeerzeugenden Zonen längs einer gebogenen Bahn so angeordnet sind, daß sie in einer ersten Richtung im Abstand voneinander liegen und daß im wesentlichen alle wärmeerzeugenden Zonen an beiden Enden in einer zweiten, zur ersten Richtung senkrechten Richtung gegeneinander versetzt sind, wodurch die Ableitung der von den wärmeerzeugenden Zonen ausgehenen Wärme erleichtert wird.

2. Integrierte Schaltung nach Anspruch 1, dadurch gekennzeichnet, daß die bogenförmige Bahn der wärmeerzeugenden Zonen V-förmig ist.

3. Integrierte Schaltung nach Anspruch 1, in der:

jede der wärmeerzeugenden Zonen ein Zentrum aufweist, wobei die Orte dieser Zentren eine V-förmige Kurve bilden, deren Arme quer von einer y-Achse ausgehen, die mit der zweiten Richtung in einer Linie verläuft, wobei jeder Arm mit der y-Achse nahe dieser y-Achse einen ersten Winkel bildet und im Bogen zu einem zweiten Winkel mit der y-Achse an seinen Enden verläuft, wobei der zweite Winkel größer als der erste Winkel gegenüber der y-Achse ist; und

die Abstände zwischen den Zentren jeder wärmeerzeugenden Zone und den Zentren benachbarter wärmeerzeugender Zonen in Querrichtung abhängig vom Abstand der wärmeerzeugenden Zone von der y-Achse zunimmt, damit eine im wesentlichen konstante Temperatur der wärmeerzeugenden Zone in allen Transistoren aufrechterhalten wird.

4. Integrierte Schaltung nach Anspruch 1, 2 oder 3, bei welcher die Transistoren Feldeffekttransistoren sind, jede der wärmeerzeugenden Zonen eine Kanalzone umfaßt, die zwischen einer jeweiligen Drain-Zone und einer Source-Zone, angeordnet auf beiden Seiten jeder Kanalzone, angeordnet ist, wobei jede der Drain-Zonen miteinander verbunden ist und jede der Source-Zonen miteinander verbunden ist.

5. Integrierte Schaltung nach Anspruch 4, enthaltend:
einen an der Oberseite gebildeten leitenden Drain-Kontakt;
einen leitenden Gate-Kontakt, der an der Oberseite so gebildet ist, daß sie in einer zweiten Richtung von dem Drain-Kontakt im Abstand liegt;
erste und zweite leitende Source-Kontakte, die an der Oberseite quer im Abstand von dem Gate-Kontakt gebildet sind;
einem ersten leitenden länglichen Gate-Verteiler, der im Abstand zwischen dem ersten Source-Kontakt und dem Drain-Kontakt an der Oberseite gebildet ist, wobei der erste Gate-Verteiler elektrisch mit dem Gate-Kontakt verbunden ist und von diesem aus diagonal zu dem Drain-Kontakt hin in einer Richtung verläuft, die zwischen der ersten und der zweiten Richtung liegt;
einem zweiten leitenden länglichen Gate-Verteiler, der an der Oberseite im Abstand zwischen dem zweiten Source-Kontakt und dem Drain-Kontakt gebildet ist, wobei der zweite Gate-Verteiler elektrisch mit dem Gate-Kontakt verbunden ist und von diesem aus diagonal zu dem Drain-Kontakt hin und von dem ersten Gate-Verteiler weg verläuft;
mehrere an der Oberseite gebildete Drain-Zonen, wobei jede Drain-Zone elektrisch mit dem Drain-Kontakt verbunden ist und im Abstand von jedem anderen liegt, wobei jede Drain-Zone zwischen dem Drain-Kontakt und einem vorbestimmten Gate-Verteiler gebildet ist;
mehrere Source-Zonen, die an der Oberseite im Abstand und mit den Drain-Zonen ineinandergreifend gebildet sind, wobei jede Source-Zone elektrisch mit einem vorgewählten Source-Kontakt verbunden ist;
mehrere in der Schicht zwischen jeweiligen Source-Zonen und Drain-Zonen gebildete Kanalzonen, wobei jede Kanalzone in der zweiten Richtung länglich ist; und
für jede Zone wenigstens eine an sie angrenzende leitende Gate-Elektrode, die elektrisch mit einem vorbestimmten Gate-Verteiler verbunden ist.

6. Integrierte Schaltung nach Anspruch 5, bei welcher an jede Kanalzone mehrere Gate-Elektroden angrenzend angeordnet sind.

7. Integrierte Schaltung nach Anspruch 5 oder 6, ferner enthaltend mehrere leitende Luftbrücken, wobei jede Luftbrücke so gebildet ist, daß sie einen jeweiligen Gate-Verteiler überspannt und einen der Source-Kontakte mit einer jeweiligen Source-Zone verbindet.

8. Integrierte Schaltung nach Anspruch 5, 6 oder 7, bei welcher die Drain-Zonen mehrere im wesentlichen parallele längliche Drain-Finger aufweisen, die sich von der Drain-Zone aus in die zweite Richtung zu dem Gate-Kontakt hin erstrecken, wobei der Drain-Kontakt eine diffundierte Zone in der Halbleiterschicht enthält, wobei jeder Drain-Finger eine einstückige Verlängerung der diffundierte Zone des Drain-Kontakts ist.

9. Integrierte Schaltung nach einem der Ansprüche 5 bis 8, bei welchem die Transistoren Metall-Halbleiter-Feldeffekttransistoren sind.

10. Integrierte Schaltung nach einem der Ansprüche 5 bis 9, bei welchem die Transistoren an dem Drain-Kontakt ein Signal erzeugen und die Gesamtabmessung der Transistoren in der ersten Richtung kleiner als eine Hälfte einer effektiven Wellenlänge des Signals ist.

11. Integrierte Schaltung nach einem der vorhergehenden Ansprüche, ferner enthaltend einen Signaleingang und einen Signalausgang, mehrere parallele Signalwege, die von dem Signaleingang zu dem Signalausgang verlaufen, wobei die Signalwege jeweiligen Transistoren zugeordnet sind und im wesentlichen die gleiche Signallaufzeitverzögerung aufweisen.

## Revendications

1. Circuit intégré (50) formé sur la face d'une couche semi-conductrice (52), comprenant une pluralité de transistors séparés (14) formés sur ladite face, trois zones de contact métalliques (90,92;84,86;62,64) reliées respectivement aux trois zones d'électrode des transistors de telle sorte que les transistors soient branchés en parallèle, chaque transistor comportant une zone active (80) dans laquelle de la chaleur est engendrée pendant le fonctionnement du circuit intégré ; les zones génératrices de chaleur étant disposées le long d'un trajet courbe de telle sorte que les zones génératrices de chaleur sont espacées l'une de l'autre selon une première direction et que pratiquement toutes les zones génératrices de chaleur sont décalées l'une de l'autre à leurs deux extrémités selon une seconde direction perpendiculaire à la première direction, ceci facilitant la dissipation de la chaleur engendrée par les zones génératrices de chaleur.

2. Circuit intégré selon la revendication 1, dans lequel ledit trajet courbe des zones génératrices de chaleur est en forme de V.

3. Circuit intégré selon la revendication 1, dans lequel :
   - chacune desdites zones génératrices de chaleur comporte un centre, le lieu géométrique desdits centres formant une courbe en forme de V comportant des bras s'étendant transversalement à partir d'un axe des y aligné avec ladite seconde direction, chacun desdits bras formant un premier angle avec ledit axe des y au voisinage de cet axe des y et s'incurvant selon un second angle par rapport audit axe des y aux extrémités de ce dernier, ledit second angle étant plus grand que ledit premier angle par rapport à l'axe des y ; et
   - les distances entre les centres de chaque zone génératrice de chaleur et les centres de zones génératrices de chaleur adjacentes selon une direction transversale augmentant en fonction de la distance de ladite zone génératrice de chaleur par rapport audit axe des y pour maintenir une température de zone génératrice de chaleur essentiellement constantes le long desdits transistors.

4. Circuit intégré selon la revendication 1, 2 ou 3, dans lequel lesdits transistors sont des transistors à effet de champ, chacune desdites zones génératrices de chaleur comprenant une zone formant canal disposée entre une zone de drain et une zone de source respectives disposées sur des côtés opposés de chacune desdites zones formant canal, lesdites zones de drain étant reliées en commun, lesdites zones de source étant reliées en commun.

5. Circuit intégré selon la revendication 4, comprenant :
   - un contact de drain conducteur formé sur ladite face ;
   - un contact de grille conducteur formé sur ladite face pour être espacé selon la seconde direction par rapport audit contact de drain ;
   - un premier et un second contacts de source conducteurs formés sur ladite face et espacés transversalement dudit contact de grille ;
   - un premier élément conducteur multiple de grille de forme allongé et formé sur ladite face de manière à se trouver espacé entre ledit premier contact de source et ledit contact de drain, ledit premier élément multiple de grille étant relié électriquement audit contact de grille et s'étendant à partir de celui-ci diagonalement en direction dudit contact de drain dans une direction comprise entre les première et seconde directions ;
   - un second élément conducteur multiple de grille allongé et formé sur ladite face pour être espacé entre ledit second contact de source et ledit contact de drain, ledit second élément multiple de grille étant relié électriquement audit contact de grille et s'étendant à partir de celui-ci diagonalement en direction dudit contact de drain en étant séparé dudit premier élément multiple de grille ;
   - une pluralité de zones de drain formées sur ladite face, chacune desdites zones de drain étant reliée électriquement audit contact de drain et étant espacée l'une de l'autre, chaque zone de drain étant formée entre ledit contact de drain et l'un prédéterminé desdits éléments multiples de grille ;
   - une pluralité de zones de source formées sur ladite face et espacées desdites zones de drain et intercalées avec celle-ci, chaque zone de source étant reliée électriquement à l'un présélectionné desdits contacts de source ;
   - une pluralité de zones de canal définies dans ladite couche entre des zones respectives desdites zones de source et desdites zones de drain, chaque zone de canal étant allongée selon la seconde direction ; et
   - pour chaque zone, au moins une électrode de grille conductrice disposée de manière adjacente à cette dernière et reliée électriquement à l'un prédéterminé desdits éléments multiples de grille.

6. Circuit intégré selon la revendication 5, dans lequel chaque zone de canal comporte une pluralité d'électrodes de grille disposées de manière adjacente à cette dernière.

7. Circuit intégré selon la revendication 5 ou 6, comprenant en outre une pluralité de ponts d'air conducteurs, chaque pont d'air étant formé pour recouvrir un élément multiple de grille respectif et reliant l'un desdits contacts de source à une zone de source respective.

8. Circuit intégré selon la revendication 5, 6 ou 7, dans lequel lesdites zones de drain comprennent une pluralité de doigts de drain allongés sensiblement parallèles s'étendant à partir de ladite zone de drain dans la seconde direction en direction dudit contact de grille, ledit contact de drain comprenant une zone diffusée dans ladite couche semi-conductrice, chacun desdits doigts de drain étant un prolongement formant une seule partie avec ladite zone diffusée de contact de drain.

9. Circuit intégré selon l'une quelconque des revendications 5 à 8, dans lequel lesdits transistors sont des transistors à effet de champ du type métal-semi-conducteur.

10. Circuit intégré selon l'une quelconque des revendications 5 à 9, dans lequel lesdits transistors produisent un signal sur ledit contact de drain et la dimension cumulée selon la première direction desdits transistors est inférieure à une moitié d'une longueur d'onde réelle dudit signal.

11. Circuit intégré selon l'une quelconque des revendications précédentes, comprenant en outre une entrée de signal et une sortie de signal, une pluralité de trajets de signal s'étendant à partir de ladite entrée de signal vers ladite sortie de signal, les trajets de signal étant associés avec des transistors respectifs et ayant essentiellement le même temps de retard de propagation du signal.

FIG. 1

FIG. 2
(PRIOR ART)

FIG. 3

FIG. 4

FIG. 5